(19) Europäisches Patentamt
European Patent Office
Office européen des brevets

(11) EP 3 465 236 B1

(12) # FASCICULE DE BREVET EUROPEEN

(45) Date de publication et mention de la délivrance du brevet:
**20.07.2022 Bulletin 2022/29**

(21) Numéro de dépôt: **17723638.7**

(22) Date de dépôt: **25.04.2017**

(51) Classification Internationale des Brevets (IPC):
***G06F 3/041*** *(2006.01)* ***G01R 27/26*** *(2006.01)*
***G06F 3/044*** *(2006.01)*

(52) Classification Coopérative des Brevets (CPC):
**G01R 27/2605; G06F 3/0443;** G06F 3/0416;
G06F 2203/04107

(86) Numéro de dépôt international:
**PCT/EP2017/059818**

(87) Numéro de publication internationale:
**WO 2017/202564 (30.11.2017 Gazette 2017/48)**

(54) **DISPOSITIF DE DETECTION CAPACITIVE A GARDE NULLE**

KAPAZITIVES ERKENNUNGSGERÄT MIT ZERO-GUARD

ZERO-GUARD CAPACITIVE DETECTION DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.05.2016 FR 1654667**

(43) Date de publication de la demande:
**10.04.2019 Bulletin 2019/15**

(73) Titulaire: **Fogale Nanotech**
**30900 Nîmes (FR)**

(72) Inventeurs:
- **NEEL, Christian**
  **30900 Nîmes (FR)**
- **OSSART, Frédéric**
  **30980 Langlade (FR)**
- **LEGROS, Eric**
  **30100 Ales (FR)**
- **ROZIERE, Didier**
  **30900 Nîmes (FR)**

(74) Mandataire: **IPAZ**
**Bâtiment Platon**
**Parc Les Algorithmes**
**91190 Saint-Aubin (FR)**

(56) Documents cités:

| | |
|---|---|
| **EP-A1- 2 876 407** | **WO-A1-2014/101943** |
| **FR-A1- 2 337 346** | **FR-A1- 2 971 867** |
| **US-A- 3 048 775** | **US-A- 3 626 287** |
| **US-A1- 2016 018 867** | **US-A1- 2016 034 102** |

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 465 236 B1

## Description

### Domaine technique

La présente invention concerne un dispositif de détection capacitif pour détecter la présence ou la proximité d'objets d'intérêts. Elle concerne aussi un appareil comprenant un tel dispositif.

Le domaine de l'invention est plus particulièrement mais de manière non limitative celui des systèmes de détection capacitifs.

### Etat de la technique antérieure

Les systèmes de détection capacitifs sont largement utilisés pour mesurer des distances ou détecter la présence ou la proximité d'objets.

Leur principe général consiste à exploiter et mesurer une capacité de couplage qui s'établit entre une ou des électrodes de mesure capacitives et des objets que l'on veut détecter. La connaissance de cette capacité permet de déduire des distances entre les électrodes et les objets.

Suivant des techniques connues, les électrodes capacitives sont excitées à un potentiel d'excitation. Lorsqu'un objet référencé à une masse générale ou à la terre (ce qui est le cas pour pratiquement tout objet) se trouve à proximité d'une électrode, il s'établit une capacité de couplage entre cette électrode et l'objet. Cette capacité de couplage peut être mesurée en mesurant le courant qui circule entre l'électrode et la masse générale à la fréquence d'excitation. Pour cela, on peut utiliser un amplificateur de charge relié en entrée à l'électrode.

Un problème qui se pose de manière générale avec ce type de mesures est que les électrodes de mesure et l'électronique sont également sensibles à des couplages capacitifs qui peuvent s'établir avec l'environnement. Cela se traduit par l'apparition de capacités de fuite parasites qui se superposent à la capacité à mesurer et génère des erreurs de mesures.

Une solution connue à ce problème est de rajouter une garde qui empêche les couplages parasites entre les électrodes de mesure capacitives et l'environnement, et éliminent donc les capacités de fuite parasites.

Cette garde peut être électriquement référencée au potentiel de masse générale. Dans ce cas, on n'empêche pas l'apparition d'une capacité de fuite parasite entre l'électrode et la garde, mais on fait l'hypothèse que cette capacité de fuite parasite est suffisamment stable dans le temps pour être calibrée. Ce genre de configuration est donc limité en termes de précision de mesure et de stabilité temporelle. En outre la nécessité de recalibration périodique entraine des contraintes d'utilisation qui peuvent être gênantes.

On connaît également des configurations de mesure qui mettent en œuvre une garde dite active. Dans ce cas la garde est excitée à un potentiel électrique sensiblement identique au potentiel des électrodes de mesure. Cette configuration a l'avantage que les couplages capacitifs éventuellement présents entre la garde et les électrodes ne produisent pas de courants de fuites et ne génèrent donc pas de capacités de fuite parasites, puisqu'il n'y a pas de différence de potentiel entre la garde et les électrodes.

Ces configurations de mesure dites « à garde active » sont largement utilisées pour faire des systèmes de mesure avec une sensibilité et une étendue de mesure importantes.

Ces systèmes sont notamment mis en œuvre sous la forme de matrices d'électrodes permettant de rendre des surfaces sensibles à leur environnement, par exemple pour faire des systèmes anticollision.

On connaît par exemple le document WO 2004/023067 qui décrit un détecteur de proximité utilisable notamment comme système d'anticollision pour des équipements médicaux. Ce document met en œuvre un procédé de mesure capacitif qui constitue une variante de configuration de mesure « à garde active » dans laquelle une partie de l'électronique de détection est également référencée au potentiel de garde pour éliminer complètement les capacités de fuite parasites.

Ces configurations de mesure « à garde active » présentent d'excellentes performances de mesures qui justifient la généralisation de leur utilisation. Toutefois leur intégration dans des systèmes électroniques complexes peut s'avérer problématique du point de vue de la compatibilité électromagnétique, du fait de la présence des éléments de garde polarisés au potentiel d'excitation.

On connaît également le document FR 2 337 346 qui décrit un procédé de mesure capacitif de grande précision qui présente l'avantage de mettre en œuvre une garde à un potentiel sensiblement équivalent au potentiel de masse général de l'électronique de détection. Toutefois ce procédé de mesure, ancien, est limité à une mesure différentielle avec une seule électrode, et repose sur une configuration à base de transformateur différentiel et de bobines d'inductances qui sont incompatibles avec des modes de réalisation en électronique intégrée. En outre, du fait du mode de transfert des alimentations électrique dans la partie gardée, la garde n'assure une protection efficace contre les capacités parasites que dans une bande fréquentielle étroite liée à une résonnance, ce qui rend la mise en œuvre de ce procédé de mesure difficile.

La présente invention a pour objet de proposer un dispositif de mesure capacitif avec une sensibilité de mesure et une immunité aux capacités de fuite parasites et à leur variations qui permettent la détection et des mesures de distances ou de contact sur des objets d'intérêt dans une étendue de mesure importante.

La présente invention a également pour but de proposer un dispositif de mesure capacitif capable de gérer une pluralité ou un grand nombre d'électrodes.

La présente invention a également pour but de proposer un dispositif de mesure capacitif qui génère un minimum de perturbations électromagnétiques, de sorte à pouvoir être facilement intégré dans un environnement électronique complexe.

La présente invention a également pour but de proposer un dispositif de mesure capacitif qui soit compatible avec une réalisation sous la forme de composants d'électronique intégrée.

**Exposé de l'invention**

Cet objectif est atteint avec un dispositif de détection capacitif comprenant :

- au moins une électrode de mesure capacitive ;
- un détecteur de courant électriquement référencé à une masse générale et sensible à un courant électrique circulant sur une entrée de mesure ;
- au moins une source de tension alternative d'excitation électriquement reliée ou couplée à l'entrée de mesure du détecteur de courant et à l'au moins une électrode de mesure capacitive ;
- des éléments de garde électriquement reliés ou couplés à l'entrée de mesure du détecteur de courant ;

Caractérisé en ce qu'il comprend en outre des moyens de génération d'alimentation électrique aptes à générer au moins une source d'alimentation électrique secondaire référencée au potentiel électrique des éléments de garde, lesquels moyens de génération d'alimentation électrique étant en outre agencés de sorte à présenter dans une bande de fréquences s'étendant depuis le continu une impédance entre la masse générale et les éléments de garde avec une composante réactive de nature capacitive ou essentiellement capacitive, ou assimilable à un circuit ouvert.

La composante réactive de l'impédance correspond à sa partie imaginaire.

Suivant des modes de réalisation, les moyens de génération d'alimentation électrique peuvent :

- être en partie référencés au potentiel de masse générale, ou comprendre des éléments référencés au potentiel de masse générale. Dans ce cas ils peuvent notamment être agencés de sorte à utiliser l'énergie d'une ou de plusieurs sources électriques d'alimentation primaires référencées au potentiel de masse générale pour générer une ou plusieurs sources électriques d'alimentation secondaires référencées au potentiel électrique des éléments de garde.
- ne pas comprendre d'éléments référencés au potentiel de masse générale. Dans ce cas ils peuvent comprendre une ou plusieurs sources d'alimentation électriques secondaires référencées au potentiel électrique des éléments de garde autonomes, telles que par exemple des batteries, des piles ou des éléments photovoltaïques.

Suivant des modes de réalisation, l'impédance des moyens de génération d'alimentation électrique entre la masse générale et les éléments de garde peut comprendre, au moins dans une bande de fréquences s'étendant depuis le continu :

- une partie imaginaire (ou une composante réactive) correspondant ou correspondant essentiellement à une capacité en série entre la masse générale et les éléments de garde ;
- une partie imaginaire (ou une composante réactive) caractérisée par une absence de composante inductive significative ;
- une valeur ou un module qui est du même ordre de grandeur, ou supérieur, à la valeur de l'impédance des capacités de couplage parasites entre la masse générale et les éléments de garde ;
- une valeur ou un module supérieur à 1 kOhm, ou 10 kOhm, ou 1 MOhm à 100 KHz, avec une composante active (partie réelle) nulle ou non-nulle ;

De manière non limitative, la bande de fréquences s'étendant depuis le continu peut s'étendre du continu à 1 KHz, ou 10 KHz, ou 200 KHz, ou 1 MHz.

Les capacités de couplage parasites entre la masse générale et les éléments de garde peuvent être par exemple de l'ordre de 400 pF, ce qui correspond à une valeur ou un module d'impédance de 4 kOhm à 100 kHz.

Les capacités de couplage parasites peuvent bien entendu avoir une valeur très différente suivant les modes de réalisation de l'invention et son environnement. Mais elles introduisent par définition une impédance entre la masse générale et les éléments de garde avec une composante réactive de nature capacitive ou essentiellement capacitive, dont le module décroît lorsque la fréquence croît.

La présence des moyens de génération d'alimentation électrique engendre potentiellement l'apparition d'une impédance entre la masse générale et les éléments de garde, distincte par définition de celle due aux capacités de couplage parasite, et en parallèle avec ces capacités de couplage parasites. Pour éviter l'apparition de courants de fuite supplémentaires significatifs, il est préférable que cette impédance des moyens de génération d'alimentation électrique soit, comme expliqué précédemment, du même ordre de grandeur, ou supérieure, à la valeur de l'impédance des capacités de couplage parasites entre la masse générale et les éléments de garde.

En outre il est préférable que cette condition soit satisfaite dans une large gamme de fréquence pour pouvoir mettre en œuvre une source de tension alternative d'excitation à une fréquence quelconque, ou de forme quelconque, ou comme cela est expliqué plus loin, pour pouvoir mettre en œuvre plusieurs sources de tension alternative d'excitation à des fréquences différentes.

La solution de l'invention est de mettre en œuvre des moyens de génération d'alimentation électrique agencés de sorte à présenter dans une bande de fréquences s'étendant depuis le continu, c'est-à-dire en particulier ou au moins pour des fréquences basses comprises dans une ou plusieurs des gammes citées précédemment, une impédance entre la masse générale et les éléments de garde avec une composante réactive de nature capacitive ou essentiellement capacitive, ou assimilable à un circuit ouvert. De cette manière, l'impédance des moyens de génération d'alimentation électrique évolue en fonction de la fréquence dans le même sens que celle due aux capacités parasites (ou reste stable et très élevée) dans une large gamme de fréquences.

Il est à noter qu'en mettant en œuvre une impédance entre la masse générale et les éléments de garde avec une composante réactive de nature inductive ou essentiellement inductive (tel que par exemple décrit dans le document FR 2 337 346), l'impédance des moyens de génération d'alimentation électrique serait nécessairement très inférieure à celle due aux capacités de couplage parasites pour les fréquences basses, ou pour des fréquences inférieures à une fréquence de résonnance du circuit constitué de l'inductance et des capacités de couplage.

Une impédance assimilable à un circuit ouvert peut être définie comme une impédance dont la valeur ou le module est très élevé (par exemple au moins 10 ou 100 fois supérieure) devant les autres impédances qui influent sur la mesure, ou au moins qui est suffisamment élevée pour pouvoir être approximée par un circuit ouvert ou une impédance infinie. Cette impédance peut comprendre une composante active (partie réelle) nulle ou non-nulle.

Le (ou les) détecteurs de courants peut comprendre tout circuit électronique permettant de mesurer une grandeur représentative d'un courant circulant sur son entrée de mesure, ou entre l'entrée de mesure et la masse générale auquel le détecteur de courant est référencé. Un tel détecteur de courant présente notamment une impédance négligeable ou au moins très faible entre l'entrée de mesure et la masse générale.

Les éléments de garde peuvent être agencés de sorte à protéger l'au moins une source de tension alternative d'excitation et l'au moins une électrode de mesure capacitive des couplages capacitifs parasites avec l'environnement, ou en d'autres termes d'éviter l'apparition de capacités de fuite parasites vers des éléments référencés au potentiel de masse générale notamment.

La source de tension alternative d'excitation et les éléments de garde peuvent être par exemple :

- directement reliés à l'entrée de mesure du détecteur de courant, par exemple par une piste de connexion ;
- reliés à l'entrée de mesure du détecteur de courant (ou dans ce cas couplés) par l'intermédiaire de composants électroniques tels que des capacités et/ou des résistances.

La source de tension alternative d'excitation et les éléments de garde peuvent être en particulier couplés à l'entrée de mesure du détecteur de courant par l'intermédiaire d'une capacité de liaison placée en série entre la source de tension alternative d'excitation et les éléments de garde d'une part et l'entrée de mesure du détecteur de courant d'autre part. Cette configuration permet de réduire le couplage, dans le détecteur de courant, du bruit généré par les perturbations électromagnétiques captées par les éléments de garde.

Suivant des modes de réalisation, le dispositif selon l'invention peut comprendre des moyens de génération d'alimentation avec des moyens de commutation électriques.

Les moyens de commutation électriques peuvent être notamment de l'un des types suivants : commutateurs, relais, switchs, transistors, diodes, jonctions PN.

Le dispositif selon l'invention peut notamment comprendre des moyens de génération d'alimentation avec :

- une première capacité de stockage ;
- une seconde capacité de stockage reliée selon une borne aux éléments de garde ; et
- au moins deux commutateurs d'alimentation agencés de sorte à relier respectivement les bornes de la première capacité de stockage, soit à une source d'alimentation électrique primaire référencée au potentiel de masse général, soit aux bornes de la seconde capacité de stockage.

Les commutateurs d'alimentation peuvent comprendre respectivement des moyens de commutation électriques. Ils peuvent être réalisés notamment sous la forme de switchs électroniques.

Dans ce mode de réalisation, les moyens de génération d'alimentation constituent une pompe de charge. La seconde capacité de stockage permet de réaliser une source d'alimentation électrique secondaire référencée au potentiel électrique des éléments de garde. La première capacité de stockage permet de répliquer la tension de la source électrique d'alimentation primaire d'une manière totalement flottante. Les commutateurs d'alimentation sont agencés pour fonctionner de manière synchrone et périodique, de sorte à relier alternativement la première capacité de stockage à la source d'alimentation électrique primaire puis à la seconde capacité de stockage. Ces commutateurs d'alimentation sont en outre agencés de sorte qu'il n'y ait jamais de liaison électrique directe entre les bornes de la source d'alimentation électrique primaire et de la seconde capacité de stockage.

Ainsi, l'impédance des moyens de génération d'alimentation électrique correspond en théorie à un circuit ouvert.

En pratique, les switchs électroniques comprennent des capacités parasites série, par exemple de l'ordre du picofarad. Il s'ensuit que l'impédance des moyens de génération d'alimentation électrique n'est jamais infinie, mais dans la mesure où ces capacités parasites sont très inférieures aux autres capacités de couplage parasites entre la masse générale et les éléments de garde, cette impédance est assimilable à un circuit ouvert.

Suivant des modes de réalisation, le dispositif selon l'invention peut comprendre un détecteur de courant avec un amplificateur de charge.

Suivant des modes de réalisation, le dispositif selon l'invention peut comprendre une source de tension alternative d'excitation avec au moins l'un des éléments suivants :

- des moyens électroniques analogiques et/ou numériques d'excitation référencés au potentiel des éléments de garde ;
- un oscillateur ;
- un convertisseur numérique-analogique ;
- un générateur de signaux de type à modulation de largeur d'impulsions ;
- un générateur de signaux de type par sous-échantillonnage d'un signal maître ;
- un FPGA ;
- un amplificateur ou un suiveur d'excitation référencé au potentiel des éléments de garde, et agencé pour recevoir en entrée un signal d'excitation maître référencé au potentiel de masse générale.

La source de tension alternative d'excitation peut ainsi générer un signal d'excitation référencé au potentiel des éléments de garde. Ce signal d'excitation peut comprendre par exemple un signal de forme sinusoïdale, triangulaire, trapézoïdale ou carrée.

Le sous-échantillonnage d'un signal maître permet de générer par exemple une pluralité de signaux d'excitation sinusoïdaux à partir d'un signal sinusoïdal maître à haute fréquence, par repliement de spectre en utilisant des fréquences d'échantillonnage qui ne satisfont pas le théorème d'échantillonnage de Nyquist-Shannon.

Le signal d'excitation peut également comprendre un signal binaire de type à modulation de largeur d'impulsion (Pulse Width Modulation, PWM en Anglais) permettant de générer par filtrage un signal analogique, triangulaire ou sinusoïdal par exemple.

Suivant des modes de réalisation, le dispositif selon l'invention peut comprendre une source de tension alternative d'excitation avec un commutateur d'excitation agencé de sorte à relier électriquement une électrode de mesure capacitive, soit à une source d'alimentation électrique secondaire, soit aux éléments de garde ou à l'entrée de mesure du détecteur de courant.

Le commutateur d'excitation peut être agencé pour commuter de manière répétitive, de sorte à générer sur l'électrode de mesure capacitive un signal alternatif d'excitation alternant entre deux niveaux de tension.

Ce signal alternatif d'excitation peut comprendre par exemple un signal binaire périodique, un signal binaire périodique selon une séquence temporelle, ou un signal de type modulation de largeur d'impulsion (Pulse Width Modulation, PWM en Anglais) permettant de générer par filtrage un signal analogique, triangulaire ou sinusoïdal par exemple.

Suivant des modes de réalisation, le dispositif selon l'invention peut comprendre une pluralité d'électrodes de mesure capacitives et des commutateurs permettant de relier séquentiellement lesdites électrodes de mesures capacitives à l'entrée de mesure du détecteur de courant, lesquels commutateurs étant agencés selon l'une des configurations suivantes :

- les commutateurs sont placés entre les électrodes de mesure et une source de tension alternative d'excitation reliée à l'entrée de mesure du détecteur de courant ;
- les commutateurs sont placés entre des sources de tension alternative d'excitation reliées respectivement à une électrode de mesure et l'entrée du détecteur de courant ;
- les commutateurs sont placés dans des sources de tension alternative d'excitation reliées respectivement à une électrode de mesure ou font partie desdites sources.

Suivant des modes de réalisation, le dispositif selon l'invention peut comprendre une pluralité d'électrodes de mesures capacitives et une pluralité de sources de tension alternatives d'excitation respectivement reliées aux électrodes de mesure capacitives et à l'entrée de mesure du détecteur de courant.

Ainsi, les électrodes de mesure capacitives peuvent être excitées respectivement par des sources de tension alternatives d'excitation distinctes. Ces sources de tension alternatives d'excitation peuvent être reliées à une même entrée de mesure du détecteur de courant.

Dans le cas où plusieurs sources de tension alternatives d'excitation sont actives simultanément, le courant électrique circulant sur l'entrée de mesure du détecteur de courant correspond sensiblement à une somme des courants circulant dans les électrodes de mesures, lesquels courants dépendent respectivement des signaux d'excitation générés par les sources de tension alternatives d'excitation.

Suivant des modes de réalisation, le dispositif selon l'invention peut comprendre :

- une pluralité de sources de tensions alternatives d'excitation réalisées sous la forme de composants distincts ; et/ou
- au moins un composant électronique regroupant plusieurs ou la totalité des sources de tensions alternatives d'excitation. Ce composant électronique peut comprendre par exemple un circuit intégré tel qu'un FPGA.

Suivant des modes de réalisation, le dispositif selon l'invention peut comprendre une pluralité de sources de tension alternative d'excitation agencées de sorte à générer des signaux d'excitation à des fréquences différentes, et/ou orthogonaux entre eux.

Ainsi, les signaux de mesure issus des électrodes de mesure sont codés différemment et peuvent être distingués.

Lorsqu'on utilise des signaux d'excitation à des fréquences différentes, chaque courant issu d'une électrode de mesure capacitive a un contenu fréquentiel différent de celui des autres électrodes. On réalise ainsi un multiplexage fréquentiel des mesures issues des électrodes capacitives.

On définit des signaux orthogonaux comme étant des signaux dont le produit scalaire de deux quelconques de ces signaux sur un nombre d'échantillons ou une durée prédéterminée est nul ou quasiment nul (par rapport au module de ces signaux, c'est-à-dire au produit scalaire de ces signaux avec eux-mêmes). En outre, on utilise la définition classique d'un produit scalaire dans un espace vectoriel muni d'une base orthonormée comme étant la somme des produits terme-à-terme des échantillons des signaux dans la durée prédéterminée.

L'utilisation signaux d'excitation orthogonaux associés à une détection synchrone comme expliqué plus loin permet démoduler les mesures issues des différentes électrodes capacitives de manière indépendante, en minimisant les effets de diaphonies (crosstalk) entre voies de mesure.

Il est à noter que des signaux d'excitation à des fréquences différentes ne sont pas orthogonaux entre eux dans le cas général. Ils peuvent toutefois être orthogonaux entre eux s'ils ont des fréquences qui correspondent à des multiples entiers les unes des autres.

Suivant des modes de réalisation, le dispositif selon l'invention peut comprendre en outre des moyens de démodulation avec au moins l'un des éléments suivants :

- un démodulateur synchrone agencé pour démoduler avec un signal de porteuse un signal de mesure modulé issu du détecteur de courant;
- un détecteur d'amplitude ;
- un démodulateur numérique.

De manière générale, un démodulateur synchrone peut se modéliser par (ou comprendre) un multiplicateur qui effectue une multiplication du signal de mesure issu du détecteur de courant avec le signal de porteuse et un filtre passe-bas.

Un détecteur d'amplitude (ou démodulateur asynchrone) peut se modéliser par (ou comprendre) un élément de redressement tel qu'un redresseur à diodes, des commutateurs à switchs ou un détecteur quadratique, et un filtre passe-bas. Il permet d'obtenir l'amplitude du signal de mesure modulé issu du détecteur de courant.

Les moyens de démodulation peuvent également comprendre des filtres passe-bande ou passe-bas anti-repliement placés avant la démodulation.

Bien entendu, les moyens de démodulation peuvent être réalisés sous forme numérique et/ou analogique. Ils peuvent notamment comprendre un convertisseur analogique-numérique et un microprocesseur et/ou un FPGA qui effectue numériquement une démodulation synchrone, une détection d'amplitude ou toute autre opération de démodulation.

Suivant des modes de réalisation, le dispositif selon l'invention peut comprendre une pluralité de sources de tension alternative d'excitation reliées à l'entrée de mesure du détecteur de courant et aptes à générer une pluralité de signaux d'excitation, et une pluralité de démodulateurs synchrones agencés pour démoduler un signal de mesure modulé issu du détecteur de courant avec des signaux de porteuse distincts, lesquels signaux de porteuse et lesquelles tensions alternatives d'excitation étant appariés de sorte qu'un signal de porteuse permette de démoduler sélectivement un signal de mesure généré par une seule source de tension alternative d'excitation.

Les signaux de porteuse et les tensions alternatives d'excitation peuvent être appariés dans le domaine fréquentiel (c'est-à-dire comprendre des fréquences en commun) et/ou dans le domaine temporel (c'est-à-dire en phase et/ou avec des formes ou des structures temporelles similaires). Les signaux de porteuse et les tensions alternatives d'excitation peuvent notamment être sensiblement identiques ou proportionnels, au moins pour leurs composantes à au moins une fréquence d'intérêt.

Suivant des modes de réalisation, le dispositif selon l'invention peut mettre en œuvre une pluralité de signaux de porteuse avec des fréquences différentes, et/ou orthogonaux entre eux.

Suivant des modes de réalisation, le dispositif selon l'invention peut comprendre au moins une source de tension alternative d'excitation agencée de sorte à générer un signal d'excitation de l'une des formes suivantes : sinusoïdale, carré, et au moins un démodulateur synchrone avec un signal de porteuse de l'une des formes suivantes : sinusoïdales, carrée.

Il peut notamment comprendre :

- au moins une source de tension alternative d'excitation agencée de sorte à générer un signal d'excitation de forme carrée, et au moins un démodulateur synchrone avec un signal de porteuse de forme sinusoïdales avec une fréquence identique à la fréquence fondamentale du signal d'excitation ;
- au moins une source de tension alternative d'excitation agencée de sorte à générer un signal d'excitation de forme carrée modulé en largeurs d'impulsions (PWM) de sorte à correspondre à un signal sinusoïdal, et au moins un démodulateur synchrone avec un signal de porteuse de forme sinusoïdales avec une fréquence identique à la fréquence du signal sinusoïdal d'excitation.

Suivant des modes de réalisation, le dispositif selon l'invention peut comprendre des moyens de transfert de signaux aptes à générer un signal référencé au potentiel de masse générale à partir d'un signal référencé au potentiel électrique des éléments de garde ou inversement, lesquels moyens de transfert de signaux comprenant au moins l'un des éléments suivants :

- un amplificateur suiveur réalisé sous la forme d'un amplificateur de charge inverseur (par exemple avec une capacité d'entrée et une capacité de contre-réaction) ;
- un montage électronique apte à générer un courant de compensation entre le potentiel de masse générale et le potentiel électrique des éléments de garde de valeur sensiblement identique et de polarité opposée à un courant de fuite.

Le courant de fuite peut être notamment dû au transfert des signaux par les moyens de transfert de signaux.

Suivant des modes de réalisation, le dispositif selon l'invention peut comprendre :

- un circuit intégré intégrant au moins l'au moins une source de tension alternative d'excitation, et au moins une partie des éléments de garde ;
- un circuit intégré avec des éléments de garde réalisés sous la forme d'un caisson de garde électriquement isolé du substrat dudit circuit intégré, lequel caisson de garde comprenant l'au moins une source de tension alternative d'excitation ;
- un circuit intégré avec un substrat référencé à la masse générale, et un détecteur de courant réalisé sur ledit substrat.

Le dispositif selon l'invention peut notamment comprendre un circuit intégré avec un caisson de garde électriquement isolé du substrat par l'un des moyens suivants :

- une succession de couches de matériau semi-conducteur avec des dopages de type P et N ;
- au moins une couche de matériaux isolant.

Ainsi, le dispositif selon l'invention peut être réalisé sous une forme adaptée à son intégration dans des appareils divers.

La réalisation sous forme de circuit intégré est notamment rendue possible par l'utilisation de composants excluant les inductances ou les transformateurs de forte valeur d'inductance.

La réalisation sous forme de circuit intégré permet en outre de réaliser de manière particulièrement efficace les éléments de garde et protéger de manière optimale la ou les sources de tension alternative d'excitation.

Suivant un autre aspect, il est proposé un appareil comprenant un dispositif de détection capacitif selon l'invention.

Suivant des modes de réalisation, l'appareil selon l'invention peut comprendre une pluralité d'électrodes capacitives disposées selon une surface dudit appareil.

L'appareil peut notamment être un robot, un appareil d'analyse ou d'imagerie médicale ou tout autre système avec une surface sensible. Les électrodes capacitives peuvent notamment être utilisées pour détecter une présence, un approche (anticollision), une distance, un contact ou pour permettre d'interagir avec l'appareil et/ou le contrôler.

Suivant des modes de réalisation, l'appareil selon l'invention peut comprendre une pluralité d'électrodes capacitives superposées ou intégrées à un écran d'affichage.

L'écran d'affichage avec les électrodes capacitives peut alors constituer une interface de commande, ou une interface homme-machine, par exemple pour contrôler des équipements médicaux, industriels...

## Description des figures et modes de réalisation

D'autres avantages et particularités de l'invention apparaîtront à la lecture de la description détaillée de mises en œuvre et de modes de réalisation nullement limitatifs, et des dessins annexés suivants :

- la Fig. 1 illustre un premier mode de réalisation de dispositif selon l'invention,
- la Fig. 2 illustre un second mode de réalisation de dispositif selon l'invention,
- la Fig. 3 illustre un troisième mode de réalisation de dispositif selon l'invention,
- la Fig. 4 illustre un quatrième mode de réalisation de dispositif selon l'invention,
- la Fig. 5 illustre un cinquième mode de réalisation de dispositif selon l'invention,
- la Fig. 6 illustre un sixième mode de réalisation de dispositif selon l'invention,
- la Fig. 7 illustre un septième mode de réalisation de dispositif selon l'invention,
- la Fig. 8 illustre un huitième mode de réalisation de dispositif selon l'invention,
- la Fig. 9 illustre un neuvième mode de réalisation de dispositif selon l'invention,
- la Fig. 10 illustre un mode de réalisation de l'invention sous la forme d'un circuit intégré.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Pour des raisons de clarté et de concision, les figures ne représentent que les éléments nécessaires à la compréhension de l'invention. Sur les figures, les éléments communs à plusieurs figures conservent la même référence.

En référence à la figure 1, on va décrire un premier mode de réalisation de dispositif de détection capacitif selon l'invention.

Le dispositif a pour objet de détecter et/ou mesurer un couplage capacitif entre un ou plusieurs objets d'intérêt 10 et une électrode de mesure capacitive 11. Par principe on suppose que le ou les objets d'intérêt 10 sont référencés à une masse générale 12 de l'électronique, qui peut être la terre. Suivant les applications, ce ou ces objets d'intérêt 10 peuvent être une partie du corps humain (une tête, une main, un doigt) ou tout autre objet.

La mesure du couplage capacitif entre le ou les objets d'intérêt 10 et l'électrode de mesure capacitive 11 peut être utilisée par exemple pour obtenir une information de contact, de distance ou de localisation, ou simplement pour détecter la présence de ce ou ces objets.

L'électrode de mesure 11 est polarisée à une tension d'excitation ou un signal d'excitation **E** par une source de tension alternative d'excitation 15 reliée en sortie à cette électrode de mesure 11. En présence d'un objet d'intérêt 10, il s'établit un courant dans l'électrode de mesure 11 qui dépend du couplage capacitif avec cet objet d'intérêt 10. Ce courant est mesuré par un détecteur de courant 16 avec une entrée de mesure à laquelle l'électrode de mesure 11 est reliée par l'intermédiaire de la source de tension alternative d'excitation 15. Dans le mode de réalisation présenté, ce détecteur de courant 16 est réalisé par un amplificateur de charge 16 représenté sous la forme d'un amplificateur opérationnel avec une entrée de mesure sur sa borne (-) et une capacité **Cr** en contre réaction. L'amplificateur de charge 16 est référencé à la masse générale 12. Il produit à sa sortie un signal de mesure sous la forme d'une tension de mesure **Vm** proportionnelle à la capacité **Cm** entre l'électrode de mesure 11 et l'objet d'intérêt 10:

$$\mathbf{Vm = - E\ Cm/Cr}.$$

Dans le mode de réalisation présenté, le signal de mesure est ensuite démodulé par un démodulateur 17 sous la forme d'un démodulateur synchrone 17 pour obtenir une valeur représentative de la capacité **Cm** (et/ou de la distance de l'objet d'intérêt 10). Le démodulateur synchrone est représenté schématiquement par un multiplieur ou un mélangeur qui effectue une multiplication du signal de mesure **Vm** par un signal de porteuse **D,** et un filtre passe-bas.

Comme cela sera détaillé plus loin, le signal de porteuse **D** peut être sensiblement identique au signal d'excitation **E,** ou au moins être apparié à ce signal d'excitation **E** de sorte à présenter des caractéristiques fréquentielles et/ou temporelles communes.

Le dispositif selon l'invention comprend également des éléments de garde 14 électriquement reliés à l'entrée de mesure du détecteur de courant 16, ou, dans le mode de réalisation présenté, à la borne (-) de l'amplificateur de charge 16. Comme la borne (+) de l'amplificateur de charge est reliée au potentiel de masse général 12, ces éléments de garde sont ainsi référencés à un potentiel de garde 13 sensiblement identique ou identique au potentiel de masse général 12, mais sans y être relié directement.

Les éléments de garde 14 peuvent comprendre tous matériaux suffisamment conducteur à l'électricité. Ils sont agencés, électriquement et spatialement, de sorte à protéger au moins l'électrode de mesure capacitive 11 et la source de tension alternative d'excitation 15 des couplages capacitifs parasites avec l'extérieur.

En pratique, ces éléments de garde 14 peuvent comprendre, de manière non limitative, un plan de garde disposé à proximité des électrodes de mesure 11 selon une face opposé à une zone de mesure, et des pistes de gardes disposées le long des pistes de liaison vers les électrodes de mesure 11. Ils peuvent comprendre en outre une enceinte englobant la source de tension alternative d'excitation 15, réalisée par exemple sous la forme d'une boîte entourant les composants électroniques (pour une réalisation sous forme discrète ou semi-intégrée).

Comme expliqué précédemment, les éléments de garde 14 ont pour objet d'éliminer tous les couplages capacitifs parasites entre l'électrode de mesure 11, la source de tension alternative d'excitation 15 et la masse générale 12. En effet, ces couplages capacitifs parasites qui pourraient apparaître en l'absence d'éléments de garde 14 selon l'invention génèreraient des courants de fuite qui s'ajouteraient directement au courant à mesurer à l'entrée de l'amplificateur de charge 16. Par ailleurs, la capacité parasite qui peut apparaître entre les éléments de garde 14 et la masse générale 12 ne génère pas de courant de fuite puisque le potentiel de masse générale 12 et le potentiel de garde 13 sont identiques.

La source de tension alternative d'excitation 15 est référencée au potentiel de garde 13. Ainsi, les capacités parasites qui peuvent apparaître entre la sortie de cette source de tension alternative d'excitation 15 et les éléments de garde 14 génèrent des courants de fuite qui se rebouclent dans les éléments de garde 14 et ne contribuent pas au courant mesuré par l'amplificateur de charge 16.

On obtient ainsi grâce à l'invention une garde de grande qualité qui élimine les couplages capacitifs parasites et permet ainsi des mesures de grande précision. Cette garde présente en outre l'avantage d'être à un potentiel similaire au potentiel de masse générale 12, et ne génère donc pas de perturbations électromagnétique dans son environnement. Enfin elle ne concerne qu'une petite partie de l'électronique puisque l'amplificateur de charge 16 et toute l'électronique de traitement sont à l'extérieur de la zone protégée par les éléments de garde 14.

Le dispositif selon l'invention comprend également des moyens de génération d'alimentation qui permettent de générer une ou plusieurs sources d'alimentation électrique secondaires référencée au potentiel de garde 13 à partir de sources d'alimentation électriques primaires référencées au potentiel de masse générale 12.

Dans les modes de réalisation présentés, ces moyens de génération d'alimentation sont agencés pour générer une source d'alimentation électrique secondaire **Vf** à partir d'une source d'alimentation électrique primaire **Vg** continue.

Cette ou ces sources d'alimentation électrique secondaires permettent notamment d'alimenter les composants électroniques référencés au potentiel de garde 13, comme la source de tension alternative d'excitation 15.

Comme expliqué précédemment, les moyens de génération d'alimentation doivent être agencés de sorte à présenter une impédance très élevée entre le potentiel de garde 13 et la masse générale 12, au moins dans la bande fréquentielle utilisée pour les mesures (soit par exemple entre 10 kHz et 200 kHz). Cela permet d'éviter les courants de fuite entre le potentiel de garde 13 et la masse générale 12 qui s'ajouteraient directement au courant à mesurer issu de l'électrode de mesure 11 à l'entrée de l'amplificateur de charge 16.

Dans les modes de réalisation présentés, les moyens de génération d'alimentation sont réalisés sous la forme d'une pompe de charge. Ils comprennent une première capacité de stockage **Ct,** une seconde capacité de stockage **Cf** reliée selon une borne au potentiel de garde 13, et deux commutateurs d'alimentation 18 agencés de sorte à relier respectivement les bornes de la première capacité de stockage **Ct,** soit à une source d'alimentation électrique primaire **Vg** référencée au potentiel de masse général 12, soit aux bornes de la seconde capacité de stockage **Cf.**

Les commutateurs d'alimentation 18 comprennent des switchs électroniques, réalisés par exemple avec des transistors de commutation de type MOS ou FET). Ils sont actionnés de manière synchrone et périodique, selon deux phases. Ainsi, ils sont agencés de sorte qu'il n'y ait jamais de liaison électrique directe entre les bornes de la source d'alimentation électrique primaire **Vg** et de la seconde capacité de stockage **Cf** (hormis par l'intermédiaire de capacités parasites, très faibles et donc de très forte impédance).

Dans une première phase, les commutateurs d'alimentation 18 sont actionnés de sorte à relier les bornes de la première capacité de stockage **Ct** respectivement à la source d'alimentation électrique primaire **Vg** et à la masse générale 12. Ainsi la tension de la source d'alimentation électrique primaire **Vg** est répliquée aux bornes de la première capacité de stockage **Ct.**

Dans une seconde phase, les commutateurs d'alimentations 18 sont actionnés de sorte à relier les bornes de la première capacité de stockage **Ct** aux bornes de la seconde capacité de stockage **Cf,** dont l'une est reliée au potentiel de garde 13. De cette manière la tension aux bornes de la première capacité de stockage **Ct** (correspondant à **Vg)** est répliquée aux bornes de la seconde capacité de stockage **Vf.**

On génère ainsi aux bornes de la seconde capacité de stockage **Cf** une source d'alimentation électrique secondaire **Vf** référencée au potentiel de garde 13 qui est une réplique de la première source d'alimentation électrique **Vg.** Les commutations des commutateurs d'alimentation 18 sont effectuées de manière suffisamment fréquente pour que la tension **Vf** aux bornes de la seconde capacité de stockage **Cf** ne varie pas trop en fonction du courant consommé par les éléments alimentés de cette manière.

La source de tension alternative d'excitation 15 peut être réalisée de toutes manières possibles.

Elle peut comprendre par exemple un oscillateur, ou un convertisseur numérique-analogique, ou un générateur de signaux implémenté par exemple avec un FPGA.

La Fig. 2 illustre un mode de réalisation avec une source de tension alternative d'excitation réalisée avec un commutateur d'excitation 20. Ce mode de réalisation a l'avantage d'être simple à implémenter.

Le commutateur d'excitation 20 est agencé de sorte à relier électriquement une électrode de mesure capacitive 11 alternativement à la source d'alimentation électrique secondaire **Vf,** et au potentiel de garde 13. Ainsi, on génère entre l'électrode de mesure capacitive 11 et l'entrée de mesure du détecteur de courant 16 un signal d'excitation **E** qui alterne entre une valeur nulle et la tension d'alimentation secondaire **Vf.**

Dans le mode de réalisation présenté, le commutateur d'excitation 20 est piloté par un signal de commande externe **h.**

Le signal d'excitation **E** ainsi généré peut comprendre par exemple un signal binaire périodique, un signal binaire périodique selon une séquence temporelle, ou un signal de type modulation de largeur d'impulsion (Pulse Width Modulation, PWM en Anglais) permettant de générer par filtrage un signal analogique, triangulaire ou sinusoïdal par exemple.

La Fig. 3 illustre un mode de réalisation qui permet de mettre en œuvre une pluralité d'électrodes de mesures capacitives 11 pour effectuer des mesures de manière séquentielle avec un même amplificateur de charges 16.

Dans ce mode de réalisation, le dispositif comprend un commutateur 30 placé entre une source de tension alternative d'excitation 15 et une pluralité d'électrodes de de mesure 11, et qui permet de sélectionner une électrode de mesure 11 particulière. Le commutateur 30 est agencé de sorte que chaque électrode de mesure 11 est reliée, soit à la source de tension alternative d'excitation 15 pour permettre une mesure, soit au potentiel de garde 13 pour contribue aux éléments de garde 14. Ce mode de réalisation permet ainsi des mesures séquentielles sur les électrodes de mesure 11.

La Fig. 4 illustre un mode de réalisation qui permet de mettre en œuvre une pluralité d'électrodes de mesures capacitives 11 pour effectuer des mesures de manière simultanée avec un même amplificateur de charges 16.

Dans ce mode de réalisation, le dispositif comprend une pluralité de sources de tension alternatives d'excitation 15 reliées chacune à une électrode de mesure 11 différente. Les sources de tension alternatives d'excitation 15 sont toutes reliées en parallèle à l'entrée de l'amplificateur de charge 16.

L'amplificateur de charge 16 est relié en sortie à une pluralité de démodulateurs 17. Ces démodulateurs 17 reçoivent donc en entrée un signal composite correspondant à l'ensemble des mesures effectuées sur les électrodes de mesure 11 reliées à l'entrée de l'amplificateur de charges.

Pour pouvoir effectuer des mesures simultanément sur les électrodes de mesures 11, on fait en sorte que chaque démodulateur 17 soit en mesure de démoduler sélectivement le signal de mesure issu d'une seule électrode de mesure 11.

Pour cela :

- les sources de tension alternatives d'excitation 15 sont agencées pour générer des signaux d'excitation différents **E1, E2,...** sur chacune des électrodes de mesure ;
- on met en œuvre des démodulateurs synchrones qui utilisent chacun un signal de porteuse **D1, D2,...** différent et apparié à un seul signal d'excitation **E1, E2,...**

Il faut en outre respecter certaines conditions sur les signaux pour éviter des diaphonies entre voies de mesures.

On peut par exemple mettre en œuvre des signaux de porteuse **D1, D2,...** orthogonaux entre eux et orthogonaux aux signaux d'excitation **E1, E2,...** à l'exception d'un seul avec lequel chaque signal de porteuse est apparié :

$$Di \cdot Dj = 0 \text{ pour } i \neq j$$

$$Di \cdot Ej = 0 \text{ pour } i \neq j$$

Cette orthogonalité peut par exemple être définie au sens du produit scalaire, lequel correspondant à une somme des produits des valeurs des signaux sur une durée temporelle.

Suivant un mode de réalisation préférentiel on réalise un multiplexage fréquentiel :

- on met en œuvre des signaux d'excitation **E1, E2,...** décalés en fréquence d'une quantité supérieure à la bande passante nécessaire pour la mesure ; et
- on utilise des signaux de porteuse **D1, D2,...** correspondant respectivement aux signaux d'excitation **E1, E2,...** ou au moins à des signaux à la fréquence fondamentale respective des signaux d'excitation **E1, E2,....**

Une façon avantageuse de réaliser ce multiplexage fréquentiel est de mettre en œuvre un circuit intégré, par exemple de type FPGA qui réalise sous la forme d'un seul composant toutes les sources de tension alternatives d'excitation 15. Ce circuit intégré est bien entendu référencé au potentiel de garde 13.

On met en œuvre une technique de modulation de largeur d'impulsion (PWM), bien connue de l'homme du métier, pour générer des signaux d'excitation **E1, E2,...** de type sinusoïdal et décalés en fréquence. Dans ce cas les signaux d'excitation correspondent à des signaux numériques oscillant entre deux valeurs, mais dont le rapport cyclique est modulé de manière sinusoïdale par exemple. Leur spectre fréquentiel comprend alors une raie à la fréquence de la sinusoïde et de l'énergie à hautes fréquences qui est naturellement filtrée par la bande passante limitée du système. L'avantage d'une telle technique est qu'elle peut être mise en œuvre avec des moyens d'électronique numérique simples et permet de générer des signaux harmoniques avec très peu de distorsion, au moins dans la bande fréquentielle d'intérêt.

Les signaux de porteuses **D1, D2,...** utilisés correspondent aux sinusoïdes générées.

La Fig. 5 illustre une variante du mode de réalisation illustré à la Fig. 4 dans lequel les sources de tension alternative d'excitation 15 sont réalisées avec des commutateurs d'excitation 20, comme expliqué en relation avec la Fig. 2.

Comme précédemment, les sources de tension alternatives d'excitation 15 peuvent avantageusement être réalisées sous la forme d'un circuit intégré.

Ce mode de réalisation permet de mettre en œuvre des signaux d'excitation **E1, E2,...** de type numérique, orthogonaux entre eux comme décrit précédemment ou décalée en fréquence pour réaliser des mesures simultanées sur toutes les voies de mesure.

Il permet également de mettre en œuvre la technique de modulation de largeur d'impulsion (PWM) décrite en relation avec la Fig. 4 pour générer des signaux d'excitation **E1, E2,...** de type sinusoïdal et décalés en fréquence.

Une problématique commune à la plupart des modes de réalisation est qu'il est nécessaire de transmettre des signaux ou des informations entre les parties de l'électronique référencées au potentiel de garde 13 et les parties de l'électronique référencées à la masse générale 12, sans générer des courants de fuite significatifs qui, comme expliqué précédemment, contribuent directement aux erreurs de mesure.

Cette transmission de signaux est notamment nécessaire pour synchroniser les sources de tension alternatives d'excitation 15 et les démodulateurs 17. Aussi les modes de réalisation décrits ci-après pour la transmission de signaux le sont en relation avec cette problématique particulière, étant entendu qu'ils sont applicables à la transmission de tous types de signaux.

Une solution idéale est d'utiliser un couplage à isolation galvanique comme un transformateur ou un opto-coupleur (couple optique émetteur-récepteur), mais ces deux techniques sont difficilement intégrables dans un circuit intégré.

En référence aux Fig. 6 et Fig. 7, on peut également utiliser des circuits de transfert avec une très haute impédance d'entrée.

Par exemple, pour transmettre un signal référencé au potentiel de garde 13 vers l'électronique référencée à la masse générale 12, on peut utiliser un circuit référencé à la masse générale 12 avec une très haute impédance d'entrée.

Cette solution est illustrée à la Fig. 6. Dans ce mode de réalisation, le signal d'excitation **E** issu d'une source de tension alternative d'excitation 15 (ou un quelconque signal de contrôle issu de cette source) est transmis à un amplificateur suiveur 60 référencé à la masse générale 12, qui est réalisé sous la forme d'un amplificateur de charge inverseur 60 avec une capacité d'entrée **Ci** reliée à sa borne (-) et une capacité de contre-réaction **Cb.**

L'impédance d'entrée de ce circuit, telle que «vue» par le signal à transmettre, est constituée essentiellement de la capacité d'entrée **Ci.** En choisissant cette capacité **Ci** de très faible valeur (quelques femtofarads par exemple) on peut obtenir une impédance d'entrée très élevée, ou en d'autres termes correspondant à une valeur de capacité de fuite proche de la capacité de fuite déjà existante entre le potentiel de garde 12 et la masse générale 13.

En choisissant une capacité de contre-réaction **Cb** avec une valeur proche de la capacité d'entrée **Ci,** on obtient un amplificateur suiveur avec un gain proche de -1, qui produit en sortie un signal référencé à la masse générale 12 qui est une image fidèle du signal d'excitation **E** référencé au potentiel de garde 13. Dans le mode de réalisation présenté, ce signal est transmis vers un démodulateur 17, par exemple pour constituer le signal de porteuse **D.**

Suivant un autre exemple, pour transmettre un signal référencé à la masse générale 12 vers l'électronique référencée au potentiel de garde, on peut utiliser un circuit référencé au potentiel de garde 13 avec une très haute impédance d'entrée.

Cette solution est illustrée à la Fig. 7. Dans ce mode de réalisation, un signal de commande **h** référencé à la masse générale 12 est transmis à la source de tension alternative d'excitation 15, laquelle est réalisée avec un commutateur d'excitation 20 tel que décrit en relation avec la Fig. 2.

Pour cela, le signal de commande **h** est relié en entrée à un amplificateur suiveur 70 référencé au potentiel de garde 13, qui est réalisé sous le forme d'un amplificateur de charge inverseur 70 avec une capacité d'entrée **Ci** reliée à sa borne (-) et une capacité de contre-réaction **Cb.**

Comme précédemment, l'impédance d'entrée de ce circuit, telle que « vue » par le signal à transmettre, est constituée de la capacité d'entrée **Ci.** En choisissant cette capacité Ci de très faible valeur (quelques femtofarads par exemple) on peut obtenir une impédance d'entrée très élevée.

En choisissant une capacité de contre-réaction Cb avec une valeur proche de la capacité d'entrée Ci, on obtient un amplificateur suiveur avec un gain proche de -1, qui produit en sortie un signal de commande référencé au potentiel de garde 13 qui est une image fidèle du signal de commande **h** référencé la masse générale 12.

En référence aux Fig. 8 et Fig. 9, une autre solution pour transmettre des signaux entre l'électronique référencée au potentiel de garde 13 et la masse générale 12 (ou inversement) consiste à générer des courants en opposition de phase, ou circulant en sens inverse, entre le potentiel de garde 13 et la masse générale 12. Ainsi, on peut annuler quasiment parfaitement ces courants de fuites, au moins aux fréquences de travail considérées.

La Fig. 8 illustre un mode de réalisation qui permet de transmettre un signal d'excitation **E** vers l'électronique référencée au potentiel de masse générale 12.

Le signal d'excitation **E** à transmettre est relié en entrée à un premier amplificateur différentiel 80 référencé au potentiel de garde 13. Ce premier amplificateur différentiel 80 est relié en sortie à un second amplificateur différentiel 81 référencé à la masse générale 12. Le premier amplificateur différentiel 80 fournit ainsi un signal différentiel au second amplificateur différentiel 81, avec deux courants qui circulent via les deux entrées du second amplificateur différentiel 81. Ces deux courants sont en opposition de phase (du moins aux fréquences du signal d'excitation **E**). Ainsi la fuite capacitive résiduelle créée est limitée par la différence de ces deux courants. L'utilisation d'un second amplificateur différentiel 81 à très haute impédance d'entrée et bien symétrique permet de limiter très efficacement la fuite capacitive résiduelle.

Dans le mode de réalisation présenté, le signal issu du second amplificateur différentiel 81 est transmis vers un démodulateur 17, par exemple pour constituer le signal de porteuse **D.**

La Fig. 9 illustre un mode de réalisation qui permet de transmettre un signal primaire d'excitation **E'** généré au niveau de l'électronique référencée au potentiel de masse générale 12 vers la source de tension alternative d'excitation 15.

Dans ce mode de réalisation, la source de tension alternative d'excitation 15 comprend un amplificateur d'excitation 90 référencé au potentiel de garde 13, qui est réalisé sous la forme d'un amplificateur de charges inverseur 90 avec une capacité d'entrée **Ci** reliée à sa borne (-) et une capacité de contre-réaction **Cb.** Cet amplificateur d'excitation 90 reçoit en entrée le signal primaire d'excitation **E'** référencé au potentiel de masse générale. Sa borne (+) est reliée au potentiel de garde 13.

Comme expliqué précédemment notamment en relation avec la Fig. 7, l'impédance d'entrée de ce circuit, telle que « vue » par le signal primaire d'excitation **E',** est constituée essentiellement de la capacité d'entrée **Ci.** En choisissant cette capacité d'entrée **Ci** de très faible valeur (quelques femtofarads par exemple) on peut obtenir une impédance d'entrée très élevée.

En choisissant une capacité de contre-réaction **Cb** avec une valeur proche de la capacité d'entrée **Ci,** on obtient un amplificateur d'excitation 90 avec un gain proche de -1, qui produit en sortie un signal d'excitation **E** référencé au potentiel de garde 13 qui est une image fidèle du signal primaire d'excitation **E'** référencé la masse générale 12.

Le signal primaire d'excitation est également transmis en entrée d'un amplificateur suiveur de compensation 91 référencé à la masse générale 12. Cet amplificateur suiveur de compensation 91 est réalisé sous la forme d'un amplificateur de charges inverseur avec une capacité d'entrée **Ci'** reliée à) sa borne (-) et une capacité de contre-réaction Cb'. La capacité d'entrée **Ci'** et la capacité de contre-réaction **Cb'** sont choisies avec des valeurs similaires, de sorte qu'il se comporte comme un amplificateur suiveur avec un gain proche de -1.

On retrouve donc en sortie de l'amplificateur suiveur de compensation 91 un signal correspondant à une réplique du signal primaire d'excitation **E'** avec un signe ou une polarité inversé.

Ce signal alimente une capacité de compensation **Cc** qui relie la sortie de l'amplificateur suiveur de compensation 91 au potentiel de garde 13. Cette capacité de compensation **Cc** est choisie de même valeur que la capacité d'entrée **Ci** de l'amplificateur d'excitation 90 référencé au potentiel de garde 13. Idéalement ces deux capacités sont en outre réalisées sur le même substrat pour présenter des caractéristiques les plus semblables possibles.

De cette manière, on génère dans la capacité de compensation **Cc** entre le potentiel de garde 13 et la masse générale 12 un courant de compensation qui est une réplique de signe opposée du courant circulant dans la capacité d'entrée **Ci** de l'amplificateur d'excitation 90. Ce courant de compensation permet d'annuler ou de compenser la fuite capacitive due à la circulation du courant dans la capacité d'entrée **Ci** de l'amplificateur d'excitation 90, entre le potentiel de garde 13 et la masse générale 12. On peut ainsi par exemple utiliser des capacités d'entrée **Ci** de plus forte valeur que pour le mode de réalisation de la Fig. 7.

Il est à noter que les amplificateurs suiveurs décrits dans les modes de réalisations des Fig. 6 à Fig. 9 peuvent aussi être réalisés avec des amplificateurs suiveurs de tension inverseurs classiques avec des résistances au lieu de capacités, ou des résistances en parallèle avec des capacités). Toutefois, les capacités ont l'avantage d'être plus faciles à réaliser que des résistances de forte valeur dans des circuits d'électronique intégrée.

En relation avec la Fig. 10, on va maintenant décrire un mode de réalisation de dispositif selon l'invention sous la forme d'un circuit intégré 100. Ce mode de réalisation est par exemple particulièrement adapté à la réalisation d'un composant permettant de contrôler un grand nombre d'électrodes de mesures capacitives 11. Il peut mettre en œuvre tous les modes de réalisation décrits précédemment en relation avec les Fig. 1 à Fig. 9.

Ce circuit intégré 100 est réalisé par exemple en technologie CMOS.

Il comprend un substrat 101, par exemple avec un dopage de type **P.** ce substrat est référencé au potentiel de masse 12, qui est le potentiel de référence des alimentations du circuit intégré 100.

Le substrat 101 comprend ou supporte la partie de l'électronique référencée au potentiel de masse générale 12, dont le détecteur de courant 16 ou l'amplificateur de charge 16. Il peut également comprendre le démodulateur 17.

Le circuit intégré 100 comprend également un caisson de garde 143 isolé électriquement du substrat 101 par une zone d'isolation 102.

La zone d'isolation 102 peut être réalisée avec un dépôt isolant ($SiO_2$).

Dans le mode de réalisation présenté, la zone d'isolation 102 est réalisée avec au moins une jonction **PN** polarisée en sens bloqué. Plus précisément, si le substrat est de type **P,** la zone d'isolation 102 comprend un dopage de type **N,** et le caisson de garde 143 comprend un dopage de type **P.** Une source de tension continue 103 applique une tension continue entre le substrat 101 et la zone d'isolation 102, pour maintenir la jonction **PN** correspondante en sens bloqué.

Le caisson de garde 143 est électriquement relié à l'entrée du détecteur de courant 16. Il est dont constitutif des éléments de garde 14 et référencé au potentiel de garde 13.

Le caisson de garde 143 comprend ou supporte les éléments électroniques référencés au potentiel de garde 13, dont les sources de tension alternative d'excitation 15.

Cette architecture a l'avantage que le caisson de garde 143 réalise une garde très efficace pour protéger les parties sensibles de l'électronique. En outre, le circuit intégré 100 est globalement référencé à la masse générale 12, donc facile à intégrer dans un système électronique.

Les électrodes de mesure 11 peuvent par exemple être réalisées de sorte à constituer une surface sensible 104. Dans ce cas, elles sont protégées selon leur face arrière par un plan de garde 141. Ce plan de garde 141 est relié au caisson de garde 143 et donc au potentiel de garde 13 de l'électronique par des éléments de garde 142 qui protègent les pistes de liaison par exemple. Le plan de garde 141 est bien entendu un élément constitutif des éléments de garde 14.

L'invention est définie par les revendications annexées.

## Revendications

**1.** Dispositif de détection capacitif comprenant :

- au moins une électrode de mesure capacitive (11) ;
- un détecteur de courant (16) électriquement référencé à une masse générale (12) et sensible à un courant électrique circulant sur une entrée de mesure ;
- au moins une source de tension alternative d'excitation (15) électriquement reliée ou couplée à l'entrée de mesure du détecteur de courant (16) et à l'au moins une électrode de mesure capacitive (11) ;
- des éléments de garde (14) électriquement reliés ou couplés à l'entrée de mesure du détecteur de courant (16) ;

**caractérisé en ce qu'**il comprend en outre des moyens de génération d'alimentation électrique aptes à générer au moins une source d'alimentation électrique secondaire (Vf) référencée au potentiel électrique des éléments de garde (13), lesquels moyens de génération d'alimentation électrique étant en outre agencés de sorte à présenter dans une bande de fréquences s'étendant depuis le continu une impédance entre la masse générale (12) et les éléments de garde (14) avec une composante réactive de nature capacitive ou essentiellement capacitive, ou assimilable à un circuit ouvert.

**2.** Dispositif selon la revendication 1, qui comprend des moyens de génération d'alimentation avec des moyens de commutation électriques (18).

**3.** Dispositif selon l'une quelconque des revendications précédentes, qui comprend des moyens de génération d'alimentation avec :

- une première capacité de stockage (Ct) ;
- une seconde capacité de stockage (Cf) reliée selon une borne aux éléments de garde (14) ; et
- au moins deux commutateurs d'alimentation (18) agencés de sorte à relier respectivement les bornes de la première capacité de stockage (Ct), soit à une source d'alimentation électrique primaire (Vg) référencée au potentiel de masse général (12), soit aux bornes de la seconde capacité de stockage (Cf).

**4.** Dispositif selon l'une quelconque des revendications précédentes, qui comprend un détecteur de courant (16) avec un amplificateur de charge.

**5.** Dispositif selon l'une quelconque des revendications précédentes, qui comprend une source de tension alternative d'excitation (15) avec au moins l'un des éléments suivants :

- des moyens électroniques analogiques et/ou numériques d'excitation référencés au potentiel des éléments de garde (13);
- un oscillateur ;
- un convertisseur numérique-analogique ;
- un générateur de signaux de type à modulation de largeur d'impulsions ;
- un générateur de signaux de type par sous-échantillonnage d'un signal maître ;
- un FPGA ;
- un amplificateur ou un suiveur d'excitation (90) référencé au potentiel des éléments de garde (13), et agencé pour recevoir en entrée un signal d'excitation maître référencé au potentiel de masse générale (12) ;
- un commutateur d'excitation (20) agencé de sorte à relier électriquement une électrode de mesure capacitive (11), soit à une source d'alimentation électrique secondaire (Vf), soit aux éléments de garde (14) ou à l'entrée de mesure du détecteur de courant (16).

**6.** Dispositif selon l'une quelconque des revendications précédentes, qui comprend une pluralité d'électrodes de mesure capacitives (11) et des commutateurs (20, 30) permettant de relier séquentiellement lesdites électrodes de mesures capacitives (11) à l'entrée de mesure du détecteur de courant (16), lesquels commutateurs (20, 30) étant agencés selon l'une des configurations suivantes :

- les commutateurs (30) sont placés entre les électrodes de mesure et une source de tension alternative d'excitation (15) reliée à l'entrée de mesure du détecteur de courant (16) ;
- les commutateurs sont placés entre des sources de tension alternative d'excitation (15) reliées respectivement à une électrode de mesure (11) et l'entrée du détecteur de courant (16);
- les commutateurs (20) sont placés dans des sources de tension alternative d'excitation (15) reliées respectivement à une électrode de mesure (11) ou font partie desdites sources (15).

**7.** Dispositif selon l'une quelconque des revendications précédentes, qui comprend une pluralité d'électrodes de mesure capacitives (11) et une pluralité de sources de tension alternatives d'excitation (15) respectivement reliées aux électrodes de mesure capacitives (11) et à l'entrée de mesure du détecteur de courant (16).

**8.** Dispositif selon la revendication 7, qui comprend une pluralité de sources de tension alternative d'excitation (15) agencées de sorte à générer des signaux d'excitation (E, E1, E2) à des fréquences différentes, et/ou orthogonaux entre eux.

**9.** Dispositif selon l'une quelconque des revendications précédentes, qui comprend en outre des moyens de démodulation (17) avec au moins l'un des éléments suivants :

- un démodulateur synchrone agencé pour démoduler avec un signal de porteuse (D, D1, D2) un signal de mesure modulé issu du détecteur de courant;
- un détecteur d'amplitude ;
- un démodulateur numérique.

**10.** Dispositif selon la revendication 9, qui comprend une pluralité de sources de tension alternative d'excitation (15) reliées à l'entrée de mesure du détecteur de courant (16) et aptes à générer une pluralité de signaux d'excitation (E, E1, E2), et une pluralité de démodulateurs synchrones (17) agencés pour démoduler un signal de mesure modulé issu du détecteur de courant (16) avec des signaux de porteuse (D, D1, D2) distincts, lesquels signaux de porteuse (D, D1, D2) et lesquelles tensions alternatives d'excitation (E, E1, E2) étant appariés de sorte qu'un signal de porteuse (D, D1, D2) permette de démoduler sélectivement un signal de mesure généré par une seule source de tension alternative d'excitation.

**11.** Dispositif selon l'une quelconque des revendications 9 ou 10, qui met en œuvre une pluralité de signaux de porteuse (D, D1, D2) avec des fréquences différentes, et/ou orthogonaux entre eux.

**12.** Dispositif selon l'une quelconque des revendications 10 ou 11, qui comprend au moins une source de tension alternative d'excitation (15) agencée de sorte à générer un signal d'excitation (E, E1, E2) de l'une des formes suivantes : sinusoïdale, carré, et au moins un démodulateur synchrone (17) avec un signal de porteuse (D, D1, D2) de l'une des formes suivantes : sinusoïdales, carrée.

**13.** Dispositif selon l'une quelconque des revendications précédentes, qui comprend des moyens de transfert de signaux (60, 70, 80, 81, 90, 91) aptes à générer un signal référencé au potentiel de masse générale (12) à partir d'un signal référencé au potentiel électrique des éléments de garde (13) ou inversement, lesquels moyens de transfert de signaux comprenant au moins l'un des éléments suivants :

- un amplificateur suiveur (60, 70, 90) réalisé sous la forme d'un amplificateur de charge inverseur ;
- un montage électronique (80, 81, 91) apte à générer un courant de compensation entre le potentiel de masse générale (12) et le potentiel électrique des éléments de garde (13) de valeur sensiblement identique et de polarité opposée à un courant de fuite.

**14.** Dispositif selon l'une quelconque des revendications précédentes, qui comprend un circuit intégré (100) intégrant au moins l'au moins une source de tension alternative d'excitation (15), et au moins une partie des éléments de garde (14).

**15.** Dispositif selon la revendication 14, qui comprend un circuit intégré (100) avec des éléments de garde (14) réalisés sous la forme d'un caisson de garde (143) électriquement isolé du substrat (101) dudit circuit intégré (100), lequel caisson de garde (143) comprenant l'au moins une source de tension alternative d'excitation (15).

**16.** Dispositif selon la revendication 15, qui comprend un circuit intégré (100) avec un substrat (101) référencé à la masse générale (12), et un détecteur de courant (16) réalisé sur ledit substrat (101).

**17.** Dispositif selon l'une quelconque des revendications 15 ou 16, qui comprend un circuit intégré (100) avec un caisson de garde (143) électriquement isolé du substrat (101) par l'un des moyens suivants :

- une succession de couches de matériau semiconducteur (102) avec des dopages de type P et N ;
- au moins une couche de matériaux isolant.

**18.** Appareil comprenant un dispositif de détection capacitif selon l'une quelconque des revendications précédentes.

**19.** Appareil selon la revendication 18, qui comprend une pluralité d'électrodes capacitives (11) disposées selon une surface dudit appareil.

**20.** Appareil selon l'une quelconque des revendications 18 ou 19, qui comprend une pluralité d'électrodes capacitives (11) superposées ou intégrées à un écran d'affichage.

**Patentansprüche**

**1.** Kapazitive Detektionsvorrichtung, umfassend:

- wenigstens eine kapazitive Messelektrode (11);
- einen Stromdetektor (16), der elektrisch auf eine allgemeine Masse (12) bezogen ist und auf einen elektrischen Strom anspricht, der an einem Messeingang fließt;
- wenigstens eine Erreger-Wechselspannungsquelle (15), die mit dem Messeingang des Stromdetektors (16) und mit der wenigstens einen kapazitiven Messelektrode (11) elektrisch verbunden oder gekoppelt ist;
- Schutzelemente (14), die mit dem Messeingang des Stromdetektors (16) elektrisch verbunden oder gekoppelt sind;

**dadurch gekennzeichnet, dass** sie ferner Mittel zum Erzeugen einer Stromversorgung umfasst, die in der Lage sind, wenigstens eine sekundäre Stromversorgungsquelle (Vf) zu erzeugen, die auf das elektrische Potential der Schutzelemente (13) bezogen ist, wobei die Mittel zum Erzeugen einer Stromversorgung ferner so angeordnet sind, dass sie in einem Frequenzband, das sich vom Gleichstrom aus erstreckt, eine Impedanz zwischen der allgemeinen Masse (12) und den Schutzelementen (14) mit einer reaktiven Komponente kapazitiver oder im Wesentlichen kapazitiver Natur, oder gleichgestellt einem offenen Kreis aufweisen.

**2.** Vorrichtung nach Anspruch 1, die Mittel zum Erzeugen einer Versorgung mit elektrischen Schaltmitteln (18) umfasst.

**3.** Vorrichtung nach einem der vorhergehenden Ansprüche, die Mittel zum Erzeugen einer Versorgung umfasst mit:

- einem ersten Speicherkondensator (Ct);
- einem zweiten Speicherkondensator (Cf), der entlang eines Anschlusses mit den Schutzelementen (14) verbunden ist; und
- wenigstens zwei Versorgungsschaltern (18), die so angeordnet sind, dass sie jeweils die Anschlüsse des ersten Speicherkondensators (Ct) entweder mit einer primären Stromversorgungsquelle (Vg) verbinden, die auf das allgemeine Massepotential (12) bezogen ist, oder mit den Anschlüssen des zweiten Speicherkondensators (Cf).

**4.** Vorrichtung nach einem der vorhergehenden Ansprüche, die einen Stromdetektor (16) mit einem Ladungsverstärker umfasst.

**5.** Vorrichtung nach einem der vorhergehenden Ansprüche, die eine Erreger-Wechselspannungsquelle (15) mit wenigstens einem der folgenden Elemente umfasst:

- analogen und/oder digitalen elektronischen Erregermitteln, die auf das Potential der Schutzelemente (13) bezogen sind;
- einem Oszillator;
- einem Digital-Analog-Wandler,
- einem Signalgenerator vom Typ Pulsweitenmodulation;
- einem Signalgenerator vom Typ durch Unterabtastung eines Mastersignals;
- einem FPGA ;
- einem Verstärker oder einen Erregungsfolger (90), der auf das Potential der Schutzelemente (13) bezogen ist und angeordnet ist, um am Eingang ein Mastererregungssignal zu empfangen, das auf das allgemeine Massepotential (12) bezogen ist;
- einem Erregungsschalter (20), der so angeordnet ist, dass er eine kapazitive Messelektrode (11) entweder mit einer sekundären Stromversorgungsquelle (Vf) oder mit den Schutzelementen (14) oder mit dem Messeingang des Stromdetektors (16) elektrisch verbindet.

**6.** Vorrichtung nach einem der vorhergehenden Ansprüche, die eine Vielzahl von kapazitiven Messelektroden (11) sowie Schalter (20,30) umfasst, die ermöglichen, die kapazitiven Messelektroden (11) sequentiell mit dem Messeingang des Stromdetektors (16) zu verbinden, wobei die Schalter (20,30) gemäß einer der folgenden Konfigurationen angeordnet sind:

- die Schalter (30) sind zwischen den Messelektroden und einer mit dem Messeingang des Stromdetektors (16) verbundenen Erreger-Wechselspannungsquelle (15) angeordnet;
- die Schalter sind zwischen Erreger-Wechselspannungsquellen (15) angeordnet, die jeweils mit einer Messelektrode (11) und dem Eingang des Stromdetektors (16) verbunden sind;

- die Schalter (20) sind in Erreger-Wechselspannungsquellen (15) angeordnet, die jeweils mit einer Messelektrode (11) verbunden sind oder Teil der Quellen (15) sind.

**7.** Vorrichtung nach einem der vorhergehenden Ansprüche, die eine Vielzahl von kapazitiven Messelektroden (11) und eine Vielzahl von Erreger-Wechselspannungsquellen (15) umfasst, welche jeweils mit den kapazitiven Messelektroden (11) und mit dem Messeingang des Stromdetektors (16) verbunden sind.

**8.** Vorrichtung nach Anspruch 7, die eine Vielzahl von Erreger-Wechselspannungsquellen (15) umfasst, welche so angeordnet sind, dass sie Erregersignale (E,E1,E2) mit unterschiedlichen Frequenzen und/oder die orthogonal zueinander sind, erzeugen.

**9.** Vorrichtung nach einem der vorhergehenden Ansprüche, die ferner Demodulationsmittel (17) mit wenigstens einem der folgenden Elemente umfasst:

- einem Synchrondemodulator, der dazu eingerichtet ist, mit einem Trägersignal (D,D1,D2) ein von dem Stromdetektor kommendes moduliertes Messsignal zu demodulieren;
- einem Amplitudendetektor;
- einem digitalen Demodulator.

**10.** Vorrichtung nach Anspruch 9, die eine Vielzahl von Erreger-Wechselspannungsquellen (15) umfasst, welche mit dem Messeingang des Stromdetektors (16) verbunden sind und geeignet sind, eine Vielzahl von Erregersignalen (E1,E1,E2) zu erzeugen, sowie eine Vielzahl von Synchrondemodulatoren (17), die dazu eingerichtet sind, ein moduliertes Messsignal, das von dem Stromdetektor (16) kommt, mit getrennten Trägersignalen (D,D1,D2) zu demodulieren, wobei die Trägersignale (D,D1,D2) und die Erreger-Wechselspannungen (E,E1,E2) derart zusammengepasst ist, dass ein Trägersignal (D,D1,D2) ermöglicht, ein Messsignal, das durch eine einzige Erreger-Wechselspannungsquelle erzeugt wird, selektiv zu demodulieren.

**11.** Vorrichtung nach einem der Ansprüche 9 oder 10, die eine Vielzahl von Trägersignalen (D,D1,D2) mit unterschiedlichen Frequenzen, und/oder die orthogonal zueinander sind, umsetzt.

**12.** Vorrichtung nach einem der Ansprüche 10 oder 11, die wenigstens eine Erreger-Wechselspannungsquelle (15) umfasst, die so angeordnet ist, dass sie ein Erregersignal (E,E1,E2) mit einer der folgenden Formen erzeugt: sinusförmig, rechteckig, und wenigstens einen Synchrondemodulator (17) mit einem Trägersignal (D,D1,D2) mit einer der folgenden Formen: sinusförmig, rechteckig.

**13.** Vorrichtung nach einem der vorangehenden Ansprüche, die Signalübertragungsmittel (60,70,80,81,90,91) umfasst, welche in der Lage sind, aus einem auf das elektrische Potential der Schutzelemente (13) bezogenen Signal ein auf das allgemeine Massepotential (12) bezogenes Signal zu erzeugen, oder umgekehrt, wobei die Signalübertragungsmittel wenigstens eines der folgenden Elemente umfassen:

- einen Folgeverstärker (60,70,90), der in Form eines invertierenden Ladungsverstärkers ausgebildet ist;
- eine elektronische Schaltung (80,81,91), die in der Lage ist, einen Ausgleichsstrom zwischen dem allgemeinen Massepotential (12) und dem elektrischen Potential der Schutzelemente (13) mit im Wesentlichen identischem Wert und mit entgegengesetzter Polarität zu einem Leckagestrom zu erzeugen.

**14.** Vorrichtung nach einem der vorhergehenden Ansprüche, die eine integrierte Schaltung (100) umfasst, in die wenigstens die wenigstens eine Erreger-Wechselspannungsquelle (15) und wenigstens einen Teil der Schutzelemente (14) integriert sind.

**15.** Vorrichtung nach Anspruch 14, die eine integrierte Schaltung (100) mit Schutzelementen (14) umfasst, die in Form eines Schutzkastens (143) ausgebildet sind, welcher von dem Substrat (101) der integrierten Schaltung (100) elektrisch isoliert ist, wobei der Schutzkasten (143) die wenigstens eine Erreger-Wechselspannungsquelle (15) umfasst.

**16.** Vorrichtung nach Anspruch 15, die eine integrierte Schaltung (100) mit einem Substrat (101), das auf die allgemeine Masse (12) bezogen ist, und einen auf dem Substrat (101) ausgebildeten Stromdetektor (16) umfasst.

**17.** Vorrichtung nach einem der Ansprüche 15 oder 16, die eine integrierte Schaltung (100) mit einem Schutzkasten (143) umfasst, welcher von dem Substrat (101) durch eines der folgenden Mittel elektrisch isoliert ist:

- eine Folge von Schichten aus Halbleitermaterial (102) mit Dotierungen vom P- und N-Typ;
- wenigstens eine Schicht aus Isolationsmaterial.

**18.** Gerät, umfassend eine kapazitive Detektionsvorrichtung nach einem der vorhergehenden Ansprüche.

**19.** Gerät nach Anspruch 18, das eine Vielzahl von kapazitiven Elektroden (11) umfasst, welche entlang einer Oberfläche des Gerätes angeordnet sind.

**20.** Gerät nach einem der Ansprüche 18 oder 19, das eine Vielzahl von kapazitiven Elektroden (11) umfasst, die übereinander angeordnet oder in einen Anzeigebildschirm integriert sind.

## Claims

**1.** Capacitive detection device comprising:

- at least one capacitive measurement electrode (11);
- a current detector (16) electrically referenced to a common ground (12) and sensitive to an electric current flowing over a measurement input;
- at least one alternating voltage excitation source (15) electrically connected or coupled to the measurement input of the current detector (16) and to the at least one capacitive measurement electrode (11);
- guard elements (14) electrically connected or coupled to the measurement input of the current detector (16);

**characterized in that** it also comprises power supply generation means suitable for generating at least one secondary power supply source (Vf) referenced to the electrical potential of the guard elements (13), said power supply generation means also being arranged so as to have, within a frequency band extending from direct current, an impedance between the common ground (12) and the guard elements (14) with a reactive component of a capacitive or essentially capacitive type, or comparable to an open circuit.

**2.** Device according to claim 1, comprising power supply generation means with electrical switching means (18).

**3.** Device according to any one of the preceding claims, comprising supply generation means with:

- a first storage capacitor (Ct);
- a second storage capacitor (Cf) connected by a terminal to the guard elements (14); and
- at least two supply commutators (18) arranged so as to connect the terminals of the first storage capacitor (Ct) respectively either to a primary power supply source (Vg) referenced to the common ground potential (12), or to the terminals of the second storage capacitor (Cf).

**4.** Device according to any one of the preceding claims, comprising a current detector (16) with a charge sensitive amplifier.

**5.** Device according to any one of the preceding claims, comprising an alternating voltage excitation source (15) with at least one of the following elements:

- analogue and/or digital electronic excitation means referenced to the potential of the guard elements (13);
- an oscillator;
- a digital-to-analogue converter;
- a signal generator of the pulse-width modulation type;
- a signal generator of the sub-sampling of a master signal type;
- an FGPA;
- an amplifier or an excitation follower (90) referenced to the potential of the guard elements (13), and arranged in order to receive at the input a master excitation signal referenced to the common ground potential (12);
- an excitation commutator (20) arranged so as to electrically connect a capacitive measurement electrode (11) either to a secondary power supply source (Vf), or to the guard elements (14) or to the measurement input of the current detector (16).

**6.** Device according to any one of the preceding claims, comprising a plurality of capacitive measurement electrodes (11) and commutators (20, 30) making it possible to sequentially connect said capacitive measurement electrodes (11) to the measurement input of the current detector (16), said commutators (20, 30) being arranged according to one of the following configurations:

- the commutators (30) are placed between the measurement electrodes and an alternating voltage excitation source (15) connected to the measurement input of the current detector (16);
- the commutators are placed between alternating voltage excitation sources (15) connected respectively to a measurement electrode (11) and the input of the current detector (16);
- the commutators (20) are placed in alternating voltage excitation sources (15) connected respectively to a measurement electrode (11) or form part of said sources (15).

**7.** Device according to any one of the preceding claims, comprising a plurality of capacitive measurement electrodes (11) and a plurality of alternating voltage excitation sources (15) respectively connected to the capacitive measurement electrodes (11) and to the measurement input of the current detector (16).

**8.** Device according to claim 7, comprising a plurality of alternating voltage excitation sources (15) arranged so as to generate excitation signals (E, **E1,** E2) at frequencies that are different, and/or orthogonal to one another.

**9.** Device according to any one of the preceding claims, also comprising demodulation means (17) with at least one of the following elements:

- a synchronous demodulator arranged in order to demodulate, with a carrier signal (D,D1,D2), a modulated measurement signal originating from the current detector;
- an amplitude detector;
- a digital demodulator.

**10.** Device according to claim 9, comprising a plurality of alternating voltage excitation sources (15) connected to the measurement input of the current detector (16) and suitable for generating a plurality of excitation signals (E,E1,E2), and a plurality of synchronous demodulators (17) arranged in order to demodulate a modulated measurement signal originating from the current detector (16) with different carrier signals (D,D1,D2), said carrier signals (D,D1,D2) and said alternating voltage excitation sources (E,E1,E2) being paired such that a carrier signal (D,D1,D2) makes it possible to selectively demodulate a measurement signal generated by a single alternating voltage excitation source.

**11.** Device according to either one of claims 9 or 10, utilizing a plurality of carrier signals **(D,D1,D2)** with frequencies that are different, and/or orthogonal to one another.

**12.** Device according to either one of claims 10 or 11, comprising at least one alternating voltage excitation source (15) arranged so as to generate an excitation signal **(E,E1,E2)** having one of the following forms: sinusoidal, square-wave, and at least one synchronous demodulator (17) with a carrier signal **(D,D1,D2)** having one of the following forms: sinusoidal, square-wave.

**13.** Device according to any one of the preceding claims, comprising signal transfer means (60,70,80,81,90,91) suitable for generating a signal referenced to the common ground potential (12) from a signal referenced to the electrical potential of the guard elements (13), or conversely, said signal transfer means comprise at least one of the following elements:

- a follower amplifier (60,70,90) produced in the form of an inverting charge amplifier;
- an electronic assembly (80,81,91) suitable for generating a compensation current between the common ground potential (12) and the electrical potential of the guard elements (13) having a value substantially identical and polarity opposite to a leakage current.

**14.** Device according to any one of the preceding claims, comprising an integrated circuit (100) incorporating at least the at least one alternating voltage excitation source (15), and at least a part of the guard elements (14).

**15.** Device according to claim 14, comprising an integrated circuit (100) with guard elements (14) produced in the form of a guard well (143) electrically isolated from the substrate (101) of said integrated circuit (100), said guard well (143) comprising the at least one alternating voltage excitation source (15).

**16.** Device according to claim 15, comprising an integrated circuit (100) with a substrate (101) referenced to the common ground (12), and a current detector (16) produced on said substrate (101).

**17.** Device according to either one of claims 15 or 16, comprising an integrated circuit (100) with a guard well (143) electrically isolated from the substrate (101) by one of the following means:

- a succession of layers of semi-conductor material (102) with P-type and N-type doping;
- at least one layer of insulating materials.

**18.** Appliance comprising a capacitive detection device according to any one of the preceding claims.

**19.** Appliance according to claim 18, comprising a plurality of capacitive electrodes (11) arranged along a surface of said device.

**20.** Appliance according to either one of claims 18 or 19, comprising a plurality of capacitive electrodes (11) superimposed on, or incorporated into, a display screen.

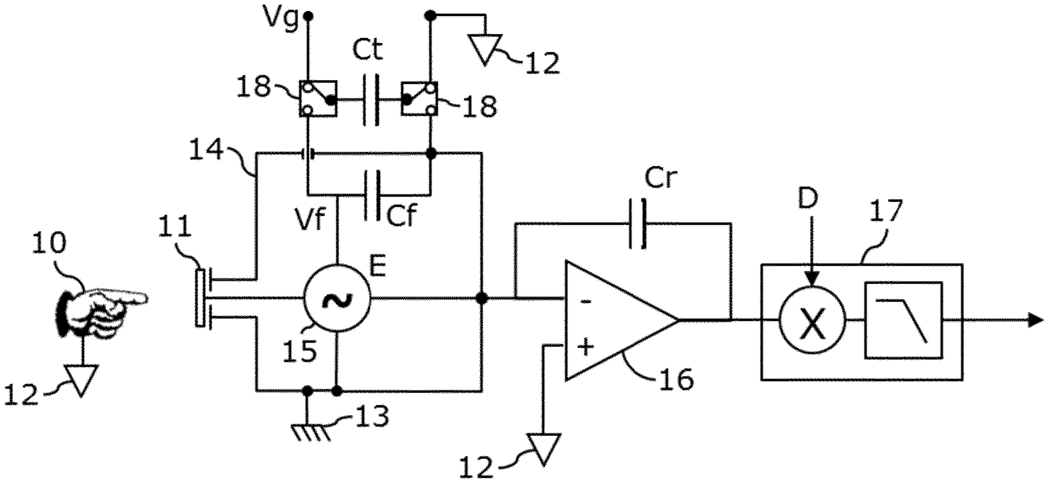


Fig. 1

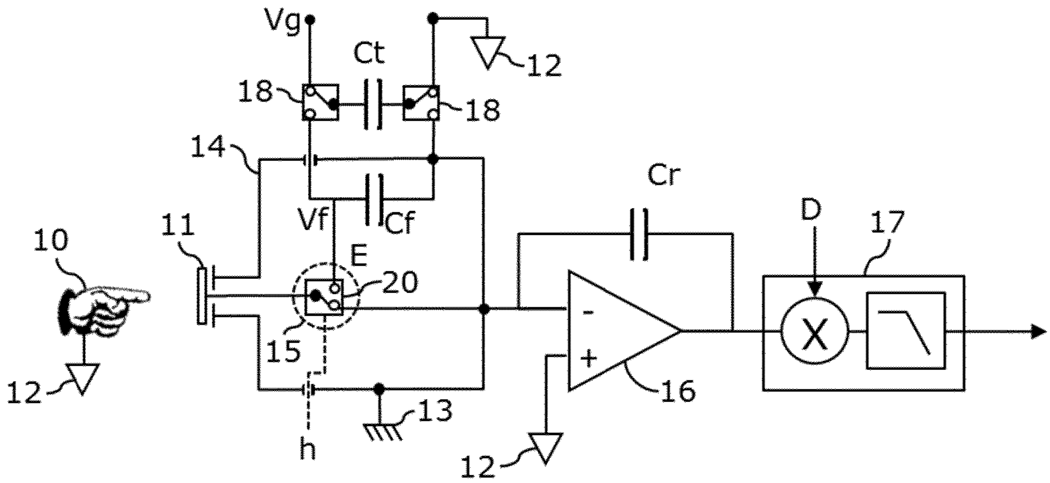


Fig. 2

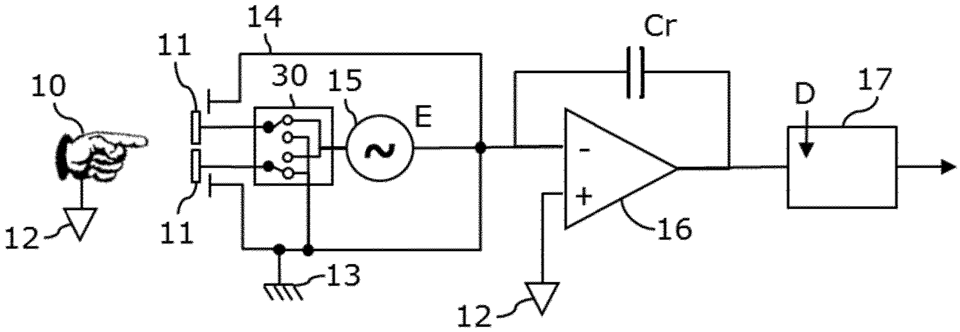


Fig. 3

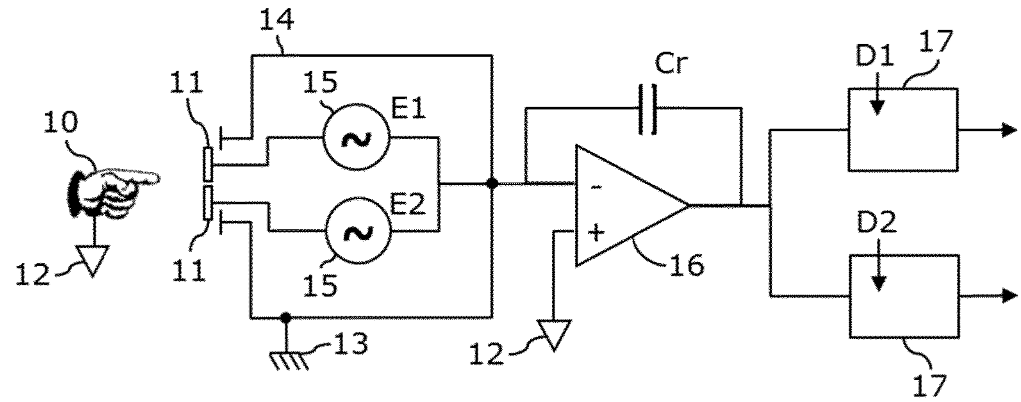


Fig. 4

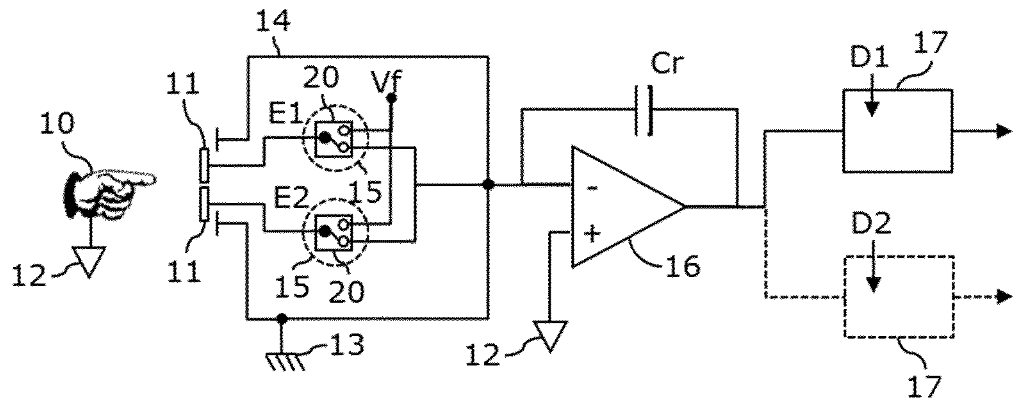


Fig. 5

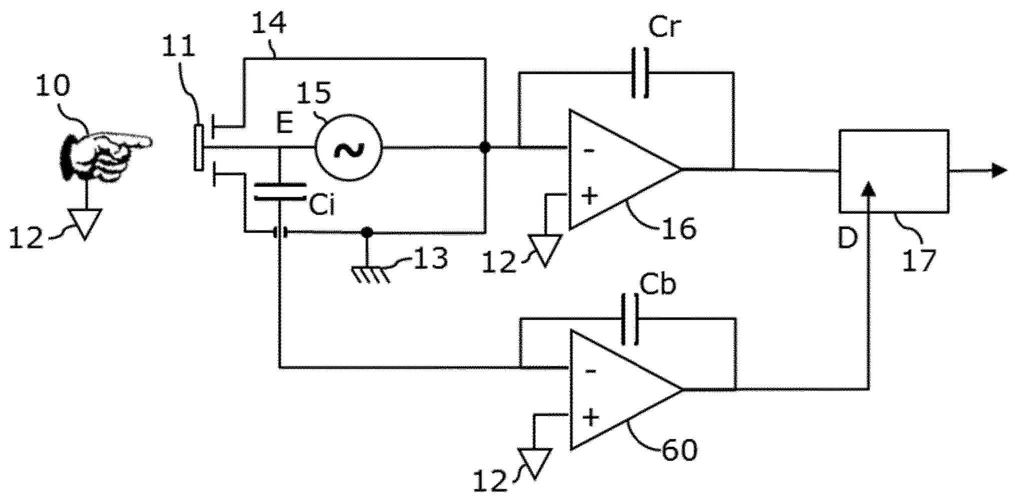


Fig. 6

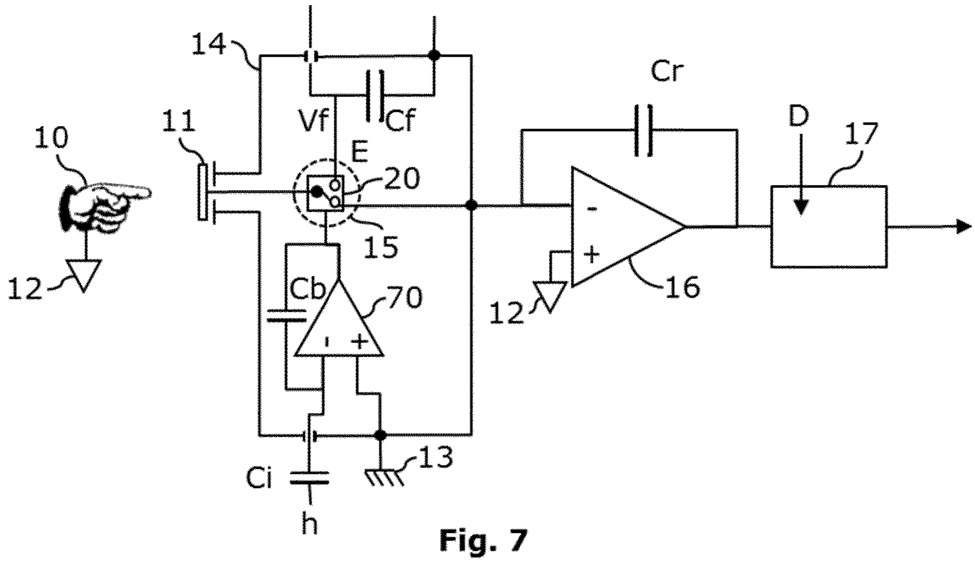


Fig. 7

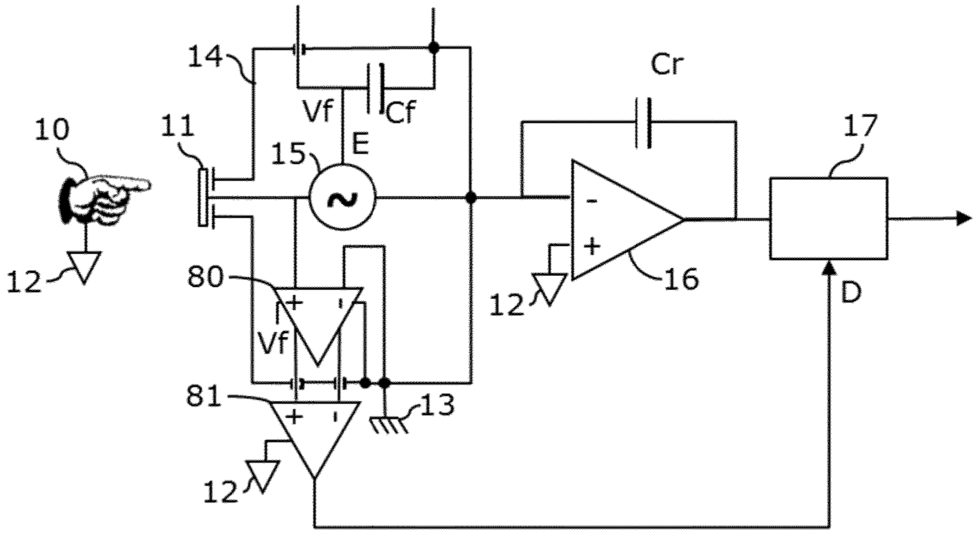


Fig. 8

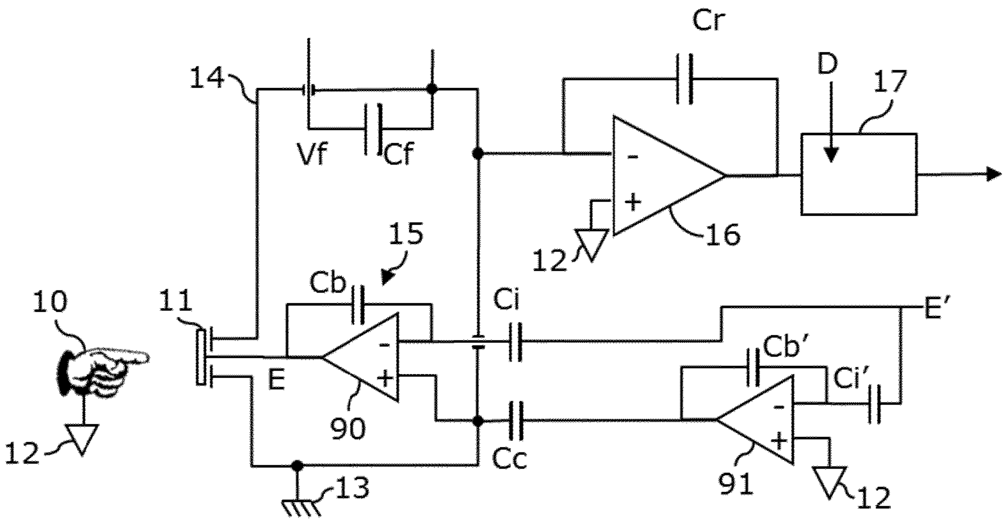


Fig. 9

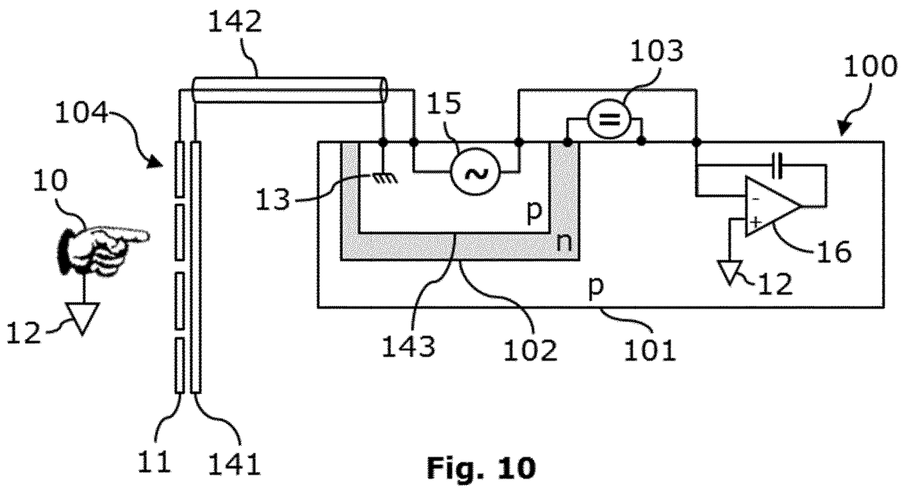


Fig. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2004023067 A
- FR 2337346